# EUROPÄISCHE PATENTANMELDUNG

(11) **EP 1 403 790 A2**
(43) Veröffentlichungstag der Anmeldung: **31.03.2004**
(21) Anmeldenummer: 03020916.7
(22) Anmeldetag: 16.09.2003
(51) Int. Cl.: G06F 17/50, G05B 19/4097

(54) **Verfahren zum Aufbau eines Technikträgers**

(30) Priorität: 24.09.2002 DE 10244691
(71) Anmelder: AUDI AG, 85045 Ingolstadt (DE)
(72) Erfinder: Huschka, Carsten, 85051 Ingolstadt (DE); Ruppert, Michael, 85368 Pfrombach (DE); Müller, Stefan, 81739 München (DE)
(74) Vertreter: Patzelt, Heike

(57) **Zusammenfassung**

Die Erfindung betrifft ein Verfahren zum Aufbau eines Technikträgers mit einer neu entwickelten Fahrzeugkomponente und einer Serienkomponente, umfassend folgende Schritte: (a) Erzeugen eines virtuellen Modells der neu entwickelten Fahrzeugkomponente; (b) Überlagern der realen Serienkomponente mit dem virtuellen Modell zu einem Mixed Reality Technikträger in einem Sichtfeld mindestens eines Anwenders durch AR (Augmented Reality); und (c) Analysieren eines Zusammenspiels des virtuellen Modells der Fahrzeugkomponente mit der Serienkomponente.

## Beschreibung

Die vorliegende Erfindung betrifft ein Verfahren zum Aufbau eines Technikträgers mit einer neu entwickelten Fahrzeugkomponente und einer Serienkomponente.

Unter einem Technikträger ist ein Versuchsfahrzeug zu verstehen, das der Erprobung von neu entwickelten Fahrzeugkomponenten dient. Ein solches Versuchsfahrzeug besteht in der Regel aus einer Serienplattform und mindestens einer Komponente aus Entwicklungsständen. Aus Geheimhaltungsgründen werden Versuchsfahrzeuge meist mit einem von Serienmodellen bekannten Erscheinungsbild versehen. Damit eine neu entwickelte Komponente, beispielsweise eine Motor-, Getriebe- oder Fahrwerkskomponente mit einer Serienkomponente, wie etwa einer Serienplattform, kombiniert werden kann, müssen diese optimal aufeinander abgestimmt sein. Diese Abstimmung erfolgt bisher durch einen virtuellen Aufbau eines Technikträgers. Sowohl von der neu entwickelten Fahrzeugkomponente als auch von der Serienkomponente werden zunächst virtuelle Modelle erzeugt, die insbesondere auf 3D-CAD Daten basiert. Durch ein sogenanntes DMU (Digital Mock-Up) System werden diese beiden virtuellen Modelle in einer virtuellen Szene kombiniert beziehungsweise zu einem virtuellen Technikträger zusammengebaut. Durch das DMU System erfolgt außerdem eine sogenannte DMU Analyse, bei der das Zusammenspiel der beiden virtuellen Modelle überprüft wird. So wird beispielsweise die Verbaubarkeit oder das funktionelle Zusammenwirken kontrolliert. Ist eine Geometrieänderung der neu entwickelten Komponente erforderlich, wird ein angepasstes virtuelles Modell erzeugt, das dann wiederum mit dem virtuellen Modell der Serienkomponente kombiniert wird. Ist keine Geometrieänderung der neu entwickelten Fahrzeugkomponente notwendig, kann ein reales Modell hergestellt werden. Dieses hergestellte reale Modell oder ein bereits existentes reales Modell der neu entwickelten Fahrzeugkomponente kann dann mit der realen Serienkomponente zu einem Technikträger aufgebaut werden. Sollten sich dabei Probleme ergeben, muss erneut eine angepasste Fahrzeugkomponente hergestellt werden.

Nachteilig an diesem Verfahren ist jedoch, dass der virtuelle Zusammenbau von neu entwickelter Fahrzeugkomponente und Serienkomponente nicht immer einen realistischen Eindruck vermittelt. Einerseits kann sich ein Anwender des Verfahrens den Technikträger trotz des virtuellen Bildes nicht so gut vorstellen, da ihm ein Bezug zur realen Umgebung fehlt. Andererseits sind bei beiden virtuellen Komponenten Form- und Lagetoleranzen zu berücksichtigen, die eine exakte Passkontrolle verhindern. Daneben ist nachteilig, dass das virtuelle Modell der Serienkomponente in der Regel keine Provisorien wie Halterungen, Klemmen, Anschlüsse etc. umfasst, so dass diese bei der Analyse der Komponentenkombination nicht berücksichtigt werden können. Sämtliche an der Serienkomponente angeordnete Provisorien in das virtuelle Modell aufzunehmen, ist dagegen sehr aufwändig. Die beschriebenen Fehlereinflussmöglichkeiten führen unter Umständen dazu, dass eine Fahrzeugkomponente so hergestellt und/oder modifiziert wird, dass diese nicht mit der Serienkomponente zum Technikträger verbaubar ist. Dies kann je nach Herstellungsaufwand zu hohen Kosten und einem großen Zeitverlust führen.

Demgemäß ist es Aufgabe der Erfindung, ein Verfahren zum Aufbau eines Technikträgers bereitzustellen, das eine bessere Kontrolle des Zusammenspiels von neu entwickelter Fahrzeugkomponente und Serienkomponente ermöglicht, so dass die beim realen Aufbau des Technikträgers auftretenden Probleme erheblich minimiert werden können.

Diese Aufgabe wird durch ein Verfahren zum Aufbau eines Technikträgers mit einer neu entwickelten Fahrzeugskomponente und einer Serienkomponente gelöst, das folgende Schritte umfasst: Zunächst wird ein virtuelles Modell der neu entwickelten Fahrzeugkomponente erzeugt. Dies kann vor allem anhand eines bereits vorliegenden Datensatzes erfolgen. Alternativ kann der Modellaufbau auch unter Verwendung von Modellen aus einem Datenarchiv erfolgen. Anschließend wird die reale Serien komponente mit dem virtuellen Modell zu einem Mixed Reality Technikträger in einem Sichtfeld mindestens eines Anwenders durch Augmented Reality (AR) überlagert, um schließlich ein Zusammenspiel des virtuellen Modells der Fahrzeugkomponente mit der Serienkomponente zu analysieren.

Augmented Reality (AR) ist eine Form der Mensch-Technik-Interaktion, bei der dem Anwender Informationen in sein Sichtfeld eingeblendet werden, beispielsweise über eine Datenbrille. Diese Einblendung erfolgt kontextabhängig, das heißt passend und abgeleitet vom betrachteten Objekt, wie in dem vorliegenden Fall von der realen Serienkomponente. Bei Verwendung einer Datenbrille, die auch als Head Mounted Display (HMD) bezeichnet wird, sind prinzipiell zwei Möglichkeiten zu unterscheiden. Bei beiden wird das zu augmentierende Objekt, also die Serienkomponente, von einer Kamera ausgehend von dem Sichtfeld eines Anwenders erfasst. Anschließend erfolgt ein Schritt, der mit "Tracking" bezeichnet werden kann. In diesem Schritt wird festgestellt, wie das zu augmentierende Objekt im Sichtfeld des Anwenders orientiert ist, um schließlich in einem sogenannten Rendering-Schritt ein Bild mit einem virtuellen Modell aufzubauen. Während in einer der beiden Möglichkeiten ein Bild entsteht, das sowohl das virtuelle Modell als auch das durch die Videokamera aufgenommene zu augmentierende Objekt umfaßt, wird bei der anderen Möglichkeit nur ein Bild des virtuellen Modells erzeugt, das der Orientierung des zu augmentierenden Objektes angepasst ist. Während in ersterem Fall dem Anwender das kombinierte Bild durch das HMD präsentiert wird, erfolgt in dem zweiten Fall eine Überlagerung des erzeugten Bildes mit dem tatsächlichen Blickfeld des Anwenders mit Hilfe eines halbdurchlässigen Spiegels. Das entstandene Bild weist also eine reale und eine virtuelle Komponente auf, so dass man von einer gemischten Wirklichkeit bzw. "Mixed Reality" spricht. Während der Mixed Reality Technikträger mit Hilfe des Head Mounted Display (HMD) lediglich einem Anwender präsentiert werden kann, kann der Mixed Reality Technikträger unter Verwendung anderer Visualisierungsverfahren in das Sichtfeld mehrerer Anwender gebracht werden, was beispielsweise mit Hilfe eines Monitors oder mindestens eines Projektors und mit entsprechenden Mono- oder Stereovisualisierungsverfahren realisiert werden kann. Mehrere Anwender können den Mixed Reality Technikträger in diesem Beispiel folglich auf dem Monitor oder als Projektion in 2D- oder 3D-Darstellung betrachten. Das erfindungsgemäße Überlagern der realen Serienkomponente mit dem virtuellen Modell zu dem Mixed Reality Technikträger kann also auch auf diese Weise oder durch ähnliche Verfahren in einem Sichtfeld mindestens eines Anwenders erfolgen.

Aufgrund der Verwendung von Augmented Reality (AR) hat der Anwender des erfindungsgemäßen Verfahrens bei der Überlagerung der realen Serienkomponente mit dem virtuellen Modell der neu entwickelten Fahrzeugkomponente einen sehr viel realistischeren Eindruck von dem Technikträger, als dies mit einem DMU System möglich wäre. Da die Serienkomponente real ist, sind bei der Überprüfung des Zusammenspiels mit dem virtuellen Modell auch keine Form- und Lagetoleranzen der Serienkomponente mehr zu berücksichtigen, wodurch diese Fehlereinflussmöglichkeit ausgeräumt wird. Außerdem weist die reale Serienkomponente alle Provisorien auf, die folglich bei der Überlagerung und der Analyse berücksichtigt werden. Aus diesen Gründen werden Probleme bei dem Zusammenbau der beiden realen Komponenten und somit dem Aufbau des Technikträgers vermieden.

Eine vorteilhafte Ausgestaltung der Erfindung sieht vor, dass in dem ersten Schritt des erfindungsgemäßen Verfahrens ein 3D-CAD- oder 3D-CAS-Modell der neu entwickelten Fahrzeugkomponente mit einem Datensatz erzeugt wird. Auf diese Weise können die im Stand der Technik verwendeten 3D-CAD- beziehungsweise 3D-CAS-Daten auch für das erfindungsgemäße Verfahren verwendet werden, so dass Kosten bei der Umstellung auf das erfindungsgemäße Verfahren minimiert werden können.

Unter Verwendung des Datensatzes des CAD- oder CAS-Modells kann auch ein Virtual Reality (VR) Modell erzeugt werden. Zu diesem Zweck werden die Daten durch eine Überführung in Dreiecksformate reduziert, was durch einen Tessiliervorgang erreicht wird. Unter einem VR-Modell ist im Sinne der Erfindung folglich ein Modell zu verstehen, das im Wesentlichen durch Dreiecksflächen der mathematisch korrekten Geometrie angenährt ist. Mit diesem reduzierten Datensatz kann optimal agiert werden, um die Positionierung des virtuellen Modells der Orientierung der Serienkomponente anzupassen.

Bei einer weiteren vorteilhaften Ausgestaltung der Erfindung kann vorgesehen sein, dass bei dem Analysieren des Zusammenspiels des virtuellen Modells der Fahrzeugkomponente mit der Serienkomponente eine Verbaubarkeit der Fahrzeugkomponente mit der Serienkomponente und/oder ein funktionelles Zusammenwirken der Fahrzeugkomponente und der Serienkomponente geprüft wird.

Bei dem Analyseschritt kann auch eine Zielposition der Fahrzeugkomponente mit entsprechenden Zielpositionskoordinaten bestimmt werden. Dies kann durch die Vorgabe der Zielpositionskoordinaten erfolgen. Außerdem können die aktuellen Koordinaten durch Eingabe entsprechender Deltawerte geändert werden. Mit Hilfe eines sogenannten Interaktionstools ist es auch möglich, das virtuelle Modell durch eine Handbewegung oder die Bewegung eines "Flying Joystick" zu verschieben und so die Zielposition der Fahrzeugkomponente festzulegen. Zusätzlich oder alternativ ist es auch möglich, eine Abstandsmessung vorzunehmen, bei der Abstände zwischen dem virtuellen Modell und der Serienkomponente an einer Stelle oder mehreren Stellen bestimmt werden. Durch die Vorgabe von Abständen kann außerdem eine optimale Zielposition bestimmt oder festgelegt werden.

Außerdem kann eine Verbindungsvorrichtung zur Verbindung der Fahrzeugkomponente mit der Serienkomponente bestimmt werden.

Eine weitere vorteilhafte Ausgestaltung der Erfindung kann vorsehen, dass bei einem in dem Analyseschritt festgestellten Mangel bezüglich des Zusammenspiels des virtuellen Modells der Fahrzeugkomponente mit der Serienkomponente das erfindungsgemäße Verfahren erneut mit einer angepassten Fahrzeugkomponente durchgeführt wird. Bei der Anpassung wird der festgestellte Mangel beseitigt. Dafür muss der Mangel zunächst detailliert analysiert werden, was anhand von Screenshots von Schnittdarstellungen des durch Überlagerung erzeugten Mixed Reality Technikträgers und/oder durch Videokameraaufnahmen von einer Folge verschiedener Ansichten erfolgen kann.

In einem weiteren Schritt des erfindungsgemäßen Verfahrens kann eine reale gegebenenfalls angepasste Fahrzeugkomponente hergestellt werden. Parallel dazu kann außerdem die oben aufgeführte Verbindungsvorrichtung hergestellt werden.

In einem weiteren Schritt des erfindungsgemäßen Verfahrens kann die reale gegebenenfalls angepasste Fahrzeugkomponente mit dem virtuellen Modell der gegebenenfalls angepassten Fahrzeugkomponente im Sichtfeld des mindestens einen Anwenders durch Augmented Reality (AR) überlagert werden, so dass gegebenenfalls eine Abweichung festgestellt werden kann, die bei einem anschließenden Herstellen einer angepassten Fahrzeugkomponente vermieden wird. In diesem Schritt erfolgt also eine Verifikation der realen Fahrzeugkomponente durch Augmentierung mit dem entsprechenden virtuellen Modell, das ein 3D-CAD- oder 3D-CAS-Modell sein kann, aber auch als VR-Modell realisierbar ist. Obwohl die reale Fahrzeugkomponente theoretisch mit dem virtuellen Modell übereinstimmen sollte, können aufgrund der Form- und Lagetoleranzen und möglichen Fehlern bei dem Herstellungsverfahren dennoch Abweichungen auftauchen, die durch diesen weiteren Schritt vor dem Aufbau des Technikträgers erkannt und daher frühzeitig behoben werden können.

In einem weiteren Schritt des erfindungsgemäßen Verfahrens können die reale gegebenenfalls angepasste Fahrzeugkomponente und die Serienkomponente zum Technikträger aufgebaut werden, wobei gegebenenfalls eine dem Zusammenspiel entgegenstehende Ausgestaltung der Fahrzeugkomponente erfassbar ist, die bei einem anschließenden Herstellen einer angepassten Fahrzeugkomponente vermieden wird.

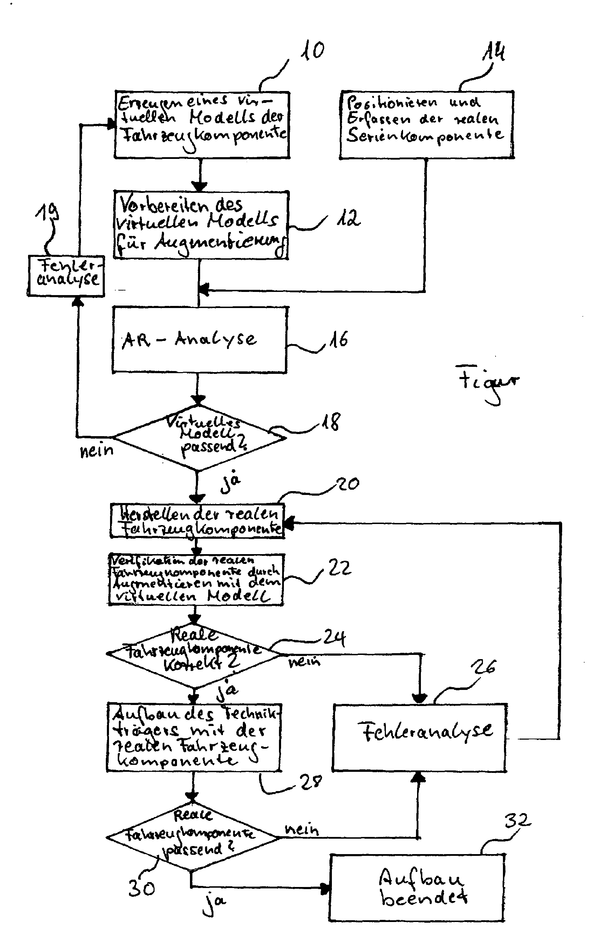

Weitere Vorteile gehen aus den im Folgenden unter Hinweis auf die beigefügte Zeichnung beschriebenen Ausführungsbeispielen hervor.
- Die Figur: zeigt ein Ablaufschema einer Ausführungsform eines erfindungsgemäßen Verfahrens zum Aufbau eines Technikträgers.

In der Figur ist ein Ablaufschema einer Variante des erfindungsgemäßen Verfahrens zum Aufbau eines Technikträgers dargestellt, der eine Serienkomponente und eine neu entwickelte Fahrzeugkomponente umfasst. Bei der neu entwickelten Fahrzeugkomponente handelt es sich beispielsweise um eine Motor-, Getriebe- oder Fahrwerkskomponente. Alternativ kann auch eine Kombination dieser oder anderer Bauteile eines Fahrzeugs als Fahrzeugkomponente im Sinne der Erfindung vorgesehen sein. Unter einer Serienkomponente im Sinne der Erfindung ist ein Bauteil oder eine Anordnung mehrerer Bauteilen zu verstehen, das oder die die Basis für den Technikträger bildet. In der Regel besteht eine solche Anordnung aus Elementen, die bereits in bestimmten Serienmodellen verwendet werden.

Vor Beginn des in der Figur beschriebenen Ablaufs kann ein Untersuchungsziel wie beispielsweise Prüfung der Verbaubarkeit und/oder des funktionellen Zusammenwirkens definiert werden. In einem ersten Schritt 10 wird dann ein virtuelles Modell der Fahrzeugkomponente erzeugt. Dabei handelt es sich insbesondere um ein 3D-CAD-Modell, das durch ein CAD-System generiert wird und anhand von Modellen eines Datenarchivs zusammengestellt werden kann. Zur Vorbereitung des virtuellen Modells für eine anschließende Augmentierung kann in Schritt 12 ein CAD-Datensatz des virtuellen Modells in einen Virtual Reality (VR) Datensatz umgewandelt werden, um den Datenumfang zu reduzieren. Dies geschieht durch Tessilieren, so dass die Daten in Dreiecksformate überführt werden. In einer alternativen Ausführungsform wird auf diesen Zwischenschritt verzichtet. In einer weiteren alternativen Ausgestaltung der Erfindung wird ein VR-Modell der Fahrzeugkomponente aus VR-Modellen eines Datenarchivs zusammengestellt. Parallel zu Schritt 12 wird in Schritt 14 die reale Serienkomponente positioniert und durch eine Kamera, insbesondere eine Videokamera, aufgenommen bzw. erfasst. Dabei wird eine sogenannte Einrichtposition definiert, durch die ein Aufnahmebereich der Kamera festgelegt wird. An der realen Serienkomponente beziehungsweise relativ dazu ist mindestens ein "Tracking Marker" vorgesehen, mit Hilfe dessen die Orientierung der realen Serienkomponente durch eine Markerkalibrierung festgestellt werden kann, so dass das virtuelle Modell bei einer Überlagerung mit der realen Serienkomponente entsprechend positionierbar ist. Außerdem wird ein Nullpunkt, das heißt ein Referenzpunkt für das virtuelle Modell definiert, der für die nachfolgende Augmented Reality (AR) Analyse benötigt wird. Dieser sogenannte Kalibriervorgang wird durch Abgleich mehrer Referenzpunkte mit ihren korrespondierenden Koordinaten durchgeführt. Die Überlagerung des virtuellen Modells mit der realen Serienkomponente erfolgt unter Verwendung des bekannten Augmented Reality (AR) Verfahrens. Vorteilhafterweise trägt ein Anwender des erfindungsgemäßen Verfahrens ein Head Mounted Display (HMD), das entweder vor seinem Auge lediglich das virtuelle Modell einblendet oder bereits eine Kombination aus realer Serienkomponente und dem virtuellen Modell sichtbar macht. In ersterem Fall sieht der Anwender durch einen halbdurchlässigen Spiegel auf die reale Serienkomponente. Der Anwender kann sich nun um die reale Serienkomponente bewegen, wobei das virtuelle Modell vor seinem Auge abgestimmt auf seine Bewegung ebenfalls bewegt wird. Alles das, was der Anwender sieht, kann ebenfalls erfasst werden und in einem Speicher abgelegt werden. In Schritt 16 erfolgt schließlich eine Augmented Reality (AR) Analyse, in der festgestellt wird, ob das virtuelle Modell der Fahrzeugkomponente mit der Serienkomponente zusammenpasst. In diesem Schritt können beispielsweise Mängel festgestellt werden, die entweder die Verbaubarkeit der beiden Komponenten und/oder das funktionelle Zusammenwirken der beiden Komponenten betreffen. Zu diesem Zweck können in Schritt 16 Kollisionen zwischen den beiden Komponenten ermittelt und eingefärbt werden. Außerdem können in verschiedenen Schnittebenen Schnitte gesetzt werden, um unter anderem auch Bemaßungen der realen Serienkomponente und des virtuellen Modells insbesondere im Vergleich zueinander durchzuführen. Zur Bestimmung einer Zielposition der Fahrzeugkomponente können einerseits Minimal- und/oder Maximal- und/oder Sollabstände zwischen den beiden Komponenten vorgegeben werden, so dass die Zielpositionskoordinaten der Zielposition bestimmt werden können. Andererseits können bestimmte Zielpositionskoordinaten vorgegeben werden oder die aktuellen Koordinaten durch Eingabe entsprechender Deltawerte geändert werden. Außerdem ist bei einer Ausführungsform der Erfindung vorgesehen, dass das virtuelle Modell ähnlich wie eine reale Komponente mit einer Hand des Anwenders verschoben werden kann. Dazu kann beispielsweise ein Datenhandschuh verwendet werden. Alternativ ist ein sogenannter Flying Joystick vorgesehen, mit dem die Position des virtuellen Modells geändert wird. Alle in Schritt 16 durchgeführten Analysemethoden können digital erfasst werden und für einen späteren Export gespeichert werden. Auf diese Weise kann auch ein dynamischer Montageweg dokumentiert und abgelegt werden. In Schritt 18 wird nun entschieden, ob das virtuelle Modell zu der realen Serienkomponente passt oder nicht. Wird ein Mangel festgestellt, wird das Verfahren über einen Fehleranalyse-Schritt 19 wieder zu Schritt 10 zurückgeschleift, wobei in Schritt 19 die Ergebnisse des Schritts 16 bewertet und in Schritt 10 zur Anpassung des virtuellen Modells verwendet werden. Zu diesem Zweck wird der im Zusammenhang mit Schritt 16 erwähnte Speicher ausgelesen. Passt das virtuelle Modell zu der realen Serienkomponente wird dieses Modell in dem folgenden Schritt 20 hergestellt. Auf eine Herstellung kann verzichtet werden, wenn das virtuelle Modell bereits auf Grundlage einer realen Fahrzeugkomponente erstellt wurde. Wurde in Schritt 16 eine Verbindungsvorrichtung für die Verbindung der Fahrzeugkomponente mit der Serienkomponente oder ein anderes Hilfsbauteil bestimmt, kann diese auch in Schritt 20 hergestellt werden.

Die nun folgenden Schritte 22 und 24 sind optional. In Schritt 22 wird die reale Fahrzeugkomponente durch Augmentierung mit dem virtuellen Modell verifiziert. Es wird also festgestellt, ob die reale Fahrzeugkomponente mit dem virtuellen Modell übereinstimmt oder ob eine Abweichung vorliegt. Dafür wird die reale Fahrzeugkomponente mit dem virtuellen Modell durch Augmented Reality (AR) überlagert. Mit Hilfe dieses Schrittes 22 kann überprüft werden, ob ein Fehler bei der Herstellung der realen Fahrzeugkomponente vorgelegen hat. Stimmt die reale Fahrzeugkomponente nicht mit dem virtuellen Modell überein, wird über Schritt 24 in Schritt 26 eine Fehleranalyse durchgeführt, so dass eine festgestellte Abweichung bei einer Herstellung einer angepassten realen Fahrzeugkomponente in Schritt 20 vermieden werden kann. Ist die reale Fahrzeugkomponente korrekt, erfolgt in Schritt 28 ein Aufbau des Technikträgers mit der realen Fahrzeugkomponente und der realen Serienkomponente. Wird in Schritt 30 festgestellt, dass die reale Fahrzeugkomponente nicht passend ist, wird in Schritt 26 eine Fehleranalyse durchgeführt und das Verfahren zu Schritt 20 zurückgeschleift. Wird hingegen in Schritt 30 festgestellt, dass die Fahrzeugkomponente passend ist, ist der Aufbau des Technikträgers mit Schritt 32 beendet.

Weitere Veränderungen und Modifikationen der oben beschriebenen Ausführungsform und der genannten Alternativen sind für den Fachmann offensichtlich und fallen ebenso unter den Schutzumfang der beigefügten Ansprüche.

## Patentansprüche

1. Verfahren zum Aufbau eines Technikträgers mit einer neu entwickelten Fahrzeugkomponente und einer Serienkomponente, umfassend folgende Schritte:
a) Erzeugen eines virtuellen Modells der neu entwickelten Fahrzeugkomponente;
b) Überlagern der realen Serienkomponente mit dem virtuellen Modell zu einem Mixed Reality Technikträger in einem Sichtfeld mindestens eines Anwenders durch AR (Augmented Reality); und
c) Analysieren eines Zusammenspiels des virtuellen Modells der Fahrzeugkomponente mit der Serienkomponente.

2. Verfahren nach Anspruch 1,
**dadurch gekennzeichnet,**
**dass** in Schritt a) ein 3D-CAD- oder 3D-CAS- Modell der neu entwickelten Fahrzeugkomponente mit einem Datensatz erzeugt wird.

3. Verfahren nach einem der Ansprüche 1 oder 2,
**dadurch gekennzeichnet,**
**dass** in Schritt a) ein VR (Virtual Reality)-Modell gegebenenfalls unter Verwendung des Datensatzes des 3D-CAD- oder 3D-CAS- Modells erzeugt wird.

4. Verfahren nach einem der vorhergehenden Ansprüche,
**dadurch gekennzeichnet,**
**dass** in Schritt c) eine Verbaubarkeit der Fahrzeugkomponente mit der Serienkomponente und/oder ein funktionelles Zusammenwirken der Fahrzeugkomponente und der Serienkomponente analysiert wird.

5. Verfahren nach einem der vorhergehenden Ansprüche,
**dadurch gekennzeichnet,**
**dass** in Schritt c) eine Zielposition der Fahrzeugkomponente mit Zielpositionskoordinaten insbesondere durch händisches Verschieben des virtuellen Modells und/oder durch Vorgabe der Zielpositionskoordinaten des virtuellen Modells und/oder Änderung der aktuellen Koordinaten des virtuellen Modells und/oder durch Vorgabe mindestens eines Minimal- und/oder Maximal- und/oder Sollabstandes zwischen dem virtuellen Modell und der Serienkomponente bestimmt wird.

6. Verfahren nach einem der vorhergehenden Ansprüche,
**dadurch gekennzeichnet,**
**dass** in Schritt c) mindestens eine Verbindungsvorrichtung zur Verbindung der Fahrzeugkomponente mit der Serienkomponente bestimmt wird.

7. Verfahren nach einem der vorhergehenden Ansprüche,
**dadurch gekennzeichnet,**
**dass** das Verfahren bei einem in Schritt c) festgestellten Mangel bezüglich des Zusammenspiels des virtuellen Modells der Fahrzeugkomponente mit der Serienkomponente nach Schritt c) erneut mit einer angepassten Fahrzeugkomponente durchgeführt wird.

8. Verfahren nach einem der vorhergehenden Ansprüche,
**dadurch gekennzeichnet,**
**dass** in einem weiteren Schritt eine reale gegebenenfalls angepasste Fahrzeugkomponente und/oder die mindestens eine Verbindungsvorrichtung hergestellt wird.

9. Verfahren nach Anspruch 8,
**dadurch gekennzeichnet,**
**dass** in einem weiteren Schritt die reale gegebenenfalls angepasste Fahrzeugkomponente mit dem virtuellen Modell der gegebenenfalls angepassten Fahrzeugkomponente durch AR (Augmented Reality) im Sichtfeld des mindestens einen Anwenders überlagert wird und gegebenenfalls eine Abweichung erfasst wird, die bei einem anschließenden Herstellen einer angepassten Fahrzeugkomponente vermieden wird.

10. Verfahren nach einem der Ansprüche 8 oder 9,
**dadurch gekennzeichnet,**
**dass** in einem weiteren Schritt die reale gegebenenfalls angepasste Fahrzeugkomponente und die Serienkomponente zum Technikträger aufgebaut werden und gegebenenfalls eine dem Zusammenspiel entgegenstehende Ausgestaltung der Fahrzeugkomponente erfasst wird, die bei einem anschließenden Herstellen einer angepassten Fahrzeugkomponente vermieden wird.
